# EUROPÄISCHE PATENTSCHRIFT

(11) **EP 2 457 106 B1**
(45) Veröffentlichungstag und Bekanntmachung des Hinweises auf die Patenterteilung: **22.08.2018**
(21) Anmeldenummer: 10720345.7
(22) Anmeldetag: 28.04.2010
(51) Int. Cl.: G01R 31/28, G01R 23/20

(54) **FREQUENZSELEKTIVE MESSVORRICHTUNG UND FREQUENZSELEKTIVES MESSVERFAHREN**
FREQUENCY-SELECTIVE MEASURING DEVICE AND FREQUENCY-SELECTIVE MEASURING METHOD
DISPOSITIF DE MESURE SÉLECTIF EN FRÉQUENCE ET PROCÉDÉ DE MESURE SÉLECTIF EN FRÉQUENCE

(30) Priorität: 21.07.2009 DE 102009034093
(43) Veröffentlichungstag der Anmeldung: 30.05.2012
(73) Patentinhaber: Rohde & Schwarz GmbH & Co. KG, 81671 München (DE)
(72) Erfinder: LECHNER, Thomas, 85551 Kirchheim (DE)
(74) Vertreter: Körfer, Thomas
(86) Internationale Anmeldenummer: PCT/EP2010/002620
(87) Internationale Veröffentlichungsnummer: WO 2011/009504

(56) Entgegenhaltungen:
- EP-A2- 0 030 724
- EP-A2- 2 012 558
- WO-A1-89/08357
- WO-A1-95/15035
- US-A- 5 402 495
- US-A1- 2009 028 357

## Beschreibung

Die Erfindung betrifft ein Messverfahren und eine Messvorrichtung zur frequenzselektiven Messung.

Audiogeräte wie Mobiltelefone und Hörgeräte verfügen oft über eine Übertragungstechnik, die an die zu übertragenden Signale angepasst ist. Daher ist es nicht immer möglich, die Übertragungseigenschaften mit synthetischen Signalen wie Sinus-Sweeps oder Multi-Sinus-Tongemischen zu ermitteln. Sprachcodecs von Mobiltelefonen verzerren das Spektrum solcher Testsignale ebenso wie frequenzabhängige Kompressoren in Hörgeräten. Die Messung des Ruhegeräusches wird oft durch sogenannte Noise-Gates verhindert, welche den Ausgang einer Übertragungsstrecke stummschalten, wenn kein Eingangssignal anliegt.

Herkömmlich wird bei der Vermessung von Mobiltelefonen ein Übertragungsfrequenzgang oft durch eine Reihe von meist lückenlosen oder überlappenden Spektraltransformationen bestimmt, deren Spektrum über die Dauer des Testsignales am Eingang und Ausgang der Übertragungsstrecke gemittelt wird. In der Norm IEEE Std. 269™-2002 vom 25. April 2003 wird ein Maß für die Unterschiedlichkeit gleichzeitig ermittelter gehörgerecht aufbereiteter Spektren am Eingang und Ausgang der Übertragungsstrecke berechnet.

EP2012558 offenbart eine Anordnung zum Ermitteln einer raumakustischen Impulsantwort.

Der Erfindung liegt die Aufgabe zu Grunde, eine Messvorrichtung und ein Messverfahren zu schaffen, welche eine zuverlässige und genaue Vermessung von Messobjekten ermöglichen.

Die Aufgabe wird erfindungsgemäß für die Vorrichtung durch die Merkmale des unabhängigen Anspruchs 1 und für das Verfahren durch die Merkmale des unabhängigen Anspruchs 6 gelöst. Vorteilhafte Weiterbildungen sind Gegenstand der hierauf rückbezogenen Unteransprüche.

Eine erfindungsgemäße Messvorrichtung verfügt über eine erste Transformationseinrichtung, eine erste Zeit-Quantisierungs-Einrichtung und eine Selektionseinrichtung. Die erste Transformationseinrichtung führt eine Transformation zumindest eines Signals in den Frequenzbereich durch. Die erste Zeit-Quantisierungs-Einrichtung teilt zumindest ein Signal in mehrere zeitlich nacheinander liegende Signale auf. Die Selektionseinrichtung führt eine Selektion von für eine Messung geeigneten Teilsignalen durch.

Die erste Transformationseinrichtung und die erste Zeit-Quantisierungs-Einrichtung verarbeiten das Messsignal nacheinander und erzeugen daraus Frequenz-Zeit-Teil-Messsignale. Dabei sind Frequenz-Zeit-Teil-Messsignale Ausschnitte des Messsignals im Zeit- und Frequenz-Bereich. Die von der Selektionseinrichtung selektierten Teil-Messsignale sind Frequenz-Zeit-Teil-Messsignale. So wird eine zuverlässige Vermessung des Messobjekts auch in schwierig zu vermessenden Frequenzbereichen erreicht.

Die Messvorrichtung beinhaltet bevorzugt weiterhin eine Synchronisationseinrichtung. Die Synchronisationseinrichtung führt eine Synchronisation des Messsignals mit einem von einem Messobjekt ausgegebenen Ausgangssignal durch. So werden eine genaue zeitliche Übereinstimmung der verglichenen Teilsignale und damit eine hohe Genauigkeit der Messung erreicht.

Die Messvorrichtung beinhaltet bevorzugt weiterhin eine zweite Transformationseinrichtung und eine zweite Zeit-Quantisierungs-Einrichtung. Die zweite Transformationseinrichtung führt vorteilhafterweise eine Transformation zumindest eines Signals in den Frequenzbereich durch. Die zweite Zeit-Quantisierungs-Einrichtung teilt zumindest ein Signal in mehrere zeitlich nacheinander liegende Signale auf. Die zweite Transformationseinrichtung und die zweite Zeit-Quantisierungs-Einrichtung verarbeiten bevorzugt das Ausgangssignal nacheinander und erzeugen daraus Frequenz-Zeit-Teil-Ausgangssignale. Dabei sind Frequenz-Zeit-Teil-Ausgangssignale Ausschnitte des Ausgangssignals im Zeit- und Frequenz-Bereich. So werden eine hohe Übereinstimmung der Teil-Messsignale und Teil-Ausgangssignale und damit eine hohe Genauigkeit der Messung erreicht.

Vorteilhafterweise verfügt die Messvorrichtung weiterhin über eine Verarbeitungseinrichtung. Die Verarbeitungseinrichtung vergleicht bevorzugt Frequenz-Zeit-Teil-Messsignale und zugehörige Frequenz-Zeit-Teil-Ausgangsssignale. Die Verarbeitungseinrichtung bestimmt bevorzugt aus dem Vergleich einen Frequenzgang und/oder ein Rauschniveau. So können mit geringem Aufwand Messergebnisse erzielt werden.

Die Selektionseinrichtung bestimmt für eine Messung geeignete Frequenz-Zeit-Teil-Messsignale durch Vergleich ihrer mittleren Leistung mit zumindest einem Schwellwert. So ist eine zuverlässige Messung hoher Genauigkeit möglich. Insbesondere bestimmt die Selektionseinrichtung für eine Messung geeignete Frequenz-Zeit-Teil-Messsignale durch Vergleich ihrer mittleren Leistung mit zumindest einem oberen und einem unteren Schwellwert. So ist eine weitere Steigerung der Zuverlässigkeit und Genauigkeit der Messung möglich.

Nachfolgend wird die Erfindung anhand der Zeichnung, in der ein vorteilhaftes Ausführungsbeispiel der Erfindung dargestellt ist, beispielhaft beschrieben. In der Zeichnung zeigen:
- Fig. 1: den Frequenzgang eines beispielhaften Sprachsignals;
- Fig. 2: ein beispielhaftes Messsignal im Zeit- und Frequenz-Bereich;
- Fig. 3: ein erstes Ausführungsbeispiel der erfindungsgemäßen Messvorrichtung;
- Fig. 4: ein zweites Ausführungsbeispiel der erfindungsgemäßen Messvorrichtung;
- Fig. 5: ein drittes Ausführungsbeispiel der erfindungsgemäßen Messvorrichtung;
- Fig. 6: ein viertes Ausführungsbeispiel der erfindungsgemäßen Messvorrichtung;
- Fig. 7: ein erstes Ausführungsbeispiel des erfindungsgemäßen Messverfahrens;
- Fig. 8: ein zweites Ausführungsbeispiel des erfindungsgemäßen Messverfahrens, und
- Fig. 9: ein drittes Ausführungsbeispiel des erfindungsgemäßen Messverfahrens.

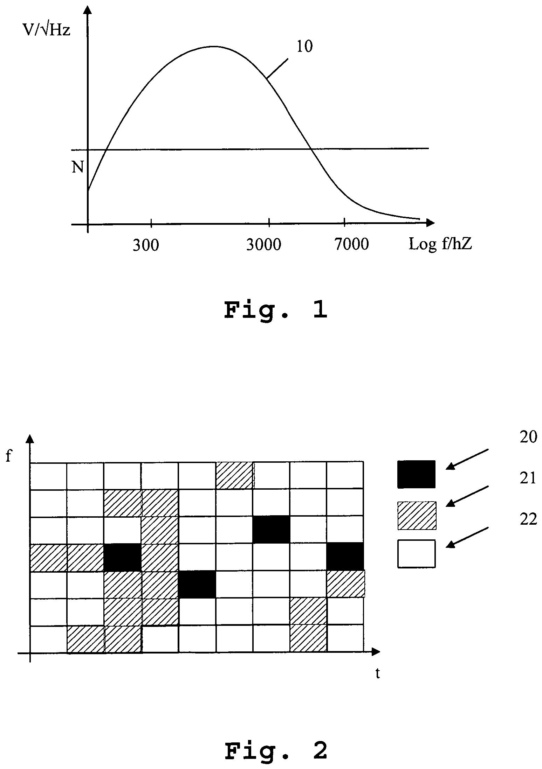

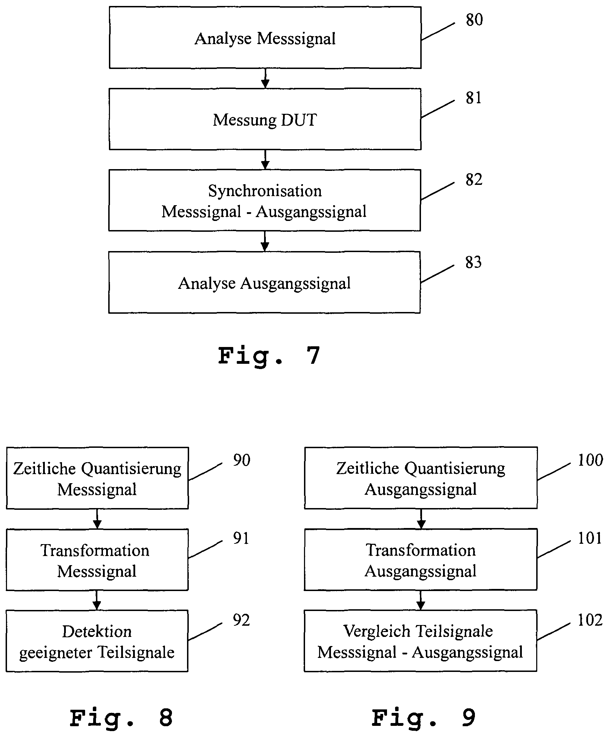

Zunächst wird anhand der Fig. 1 die dem erfindungsgemäßen Messverfahren und der erfindungsgemäßen Messvorrichtung zu Grunde liegende Problematik erläutert. Mittels Fig. 2 - 6 wird der Aufbau und die Funktionsweise der erfindungsgemäßen Vorrichtung gezeigt. Anhand der Fig. 7 -9 wird anschließend die Funktionsweise des erfindungsgemäßen Messverfahrens dargestellt. Identische Elemente wurden in ähnlichen Abbildungen zum Teil nicht wiederholt dargestellt und beschrieben.

In Fig. 1 ist das gemittelte Spektrum 10 eines beispielhaften Sprachsignals dargestellt. Deutlich wird dabei, dass die Leistung des Sprachsignals weitgehend im Bereich zwischen 300 und 3000 Hz vorliegt. Insbesondere bei hohen Frequenzen, z.B. 7000 Hz liegt die Leistung des Sprachsignals unterhalb des Rauschniveaus N.

Zur Ermittlung eines Frequenzgangs ist es jedoch notwendig, auch Frequenzbereiche, bei welchen typische Sprachsignale lediglich geringe Leistungsanteile aufweisen, zu vermessen. Darüber hinaus bereitet es Schwierigkeiten, bei Einsatz von natürlichen Sprachsignalen als Messsignal das Ruhe-Rauschniveau zu ermitteln, da Noise-Gates (Rausch-Gatter) den Ausgang stummschalten, sobald das Eingangssignal unterhalb einer bestimmten Schwelle liegt.

In Fig. 2 ist ein beispielhaftes Messsignal gleichzeitig im Zeit- und Frequenz-Bereich dargestellt. Das Messsignal ist dabei in Zeit-Frequenz-Teil-Messsignale 20, 21, 22 quantisiert. Die Darstellung der einzelnen Zeit-Frequenz-Teil-Messsignale 20, 21, 22 gibt dabei den Pegel an. In schwarz dargestellte Zeit-Frequenz-Teil-Messsignale 20 weisen einen Pegel auf, welcher eine Übersteuerung oder zumindest eine Sättigung anzeigt. Zeit-Frequenz-Teil-Messsignale 21, welche schraffiert dargestellt sind, weisen einen mittleren Pegel auf und sind damit zur Bestimmung eines Frequenzgangs des Messobjekts geeignet. Zeit-Frequenz-Teil-Messsignale 22, welche weiß dargestellt sind, weisen einen sehr niedrigen Pegel auf und sind damit zur Bestimmung des Ruhe-Rauschniveaus in dem jeweiligen Frequenzbereich geeignet.

Soll der Frequenzgang eines Messobjekts bestimmt werden, wird das Messobjekt mit dem gesamten Messsignal beaufschlagt. Zur Bestimmung des Frequenzgangs werden jedoch im Ausgangssignal des Messobjekts lediglich die Zeit-Frequenz-Teil-Ausgangssignale, welche den Zeit-Frequenz-Teil-Messsignalen 21 entsprechen, herangezogen. Soll dagegen das Ruhe-Rauschniveau ermittelt werden, wird das Messobjekt mit dem gesamten Messsignal beaufschlagt, während jedoch das Ruhe-Rauschniveau lediglich aus den Zeit-Frequenz-Teil-Ausgangssignalen, welche den Zeit-Frequenz-Teil-Messsignalen 22 entsprechen, bestimmt wird. Solange in zumindest einem Frequenzbereich ein Pegel vorliegt, schaltet das Noise-Gate des Messobjekts den Ausgang nicht stumm, und die übrigen Frequenzbereiche, auf denen kein Pegel vorliegt, können hinsichtlich des Ruhe-Rauschniveaus vermessen werden.

Liegen zur Bestimmung des Ruhe-Rauschniveaus nicht in sämtlichen Frequenzbereichen genügend geeignete Teilsignale vor, so ist darüber hinaus eine gezielte Stummschaltung einzelner Teilsignale möglich. Da stets lediglich kurzzeitig einzelne Frequenzbereiche stumm geschaltet werden, ist keine Beeinträchtigung des Messobjekts durch diese Manipulation zu befürchten.

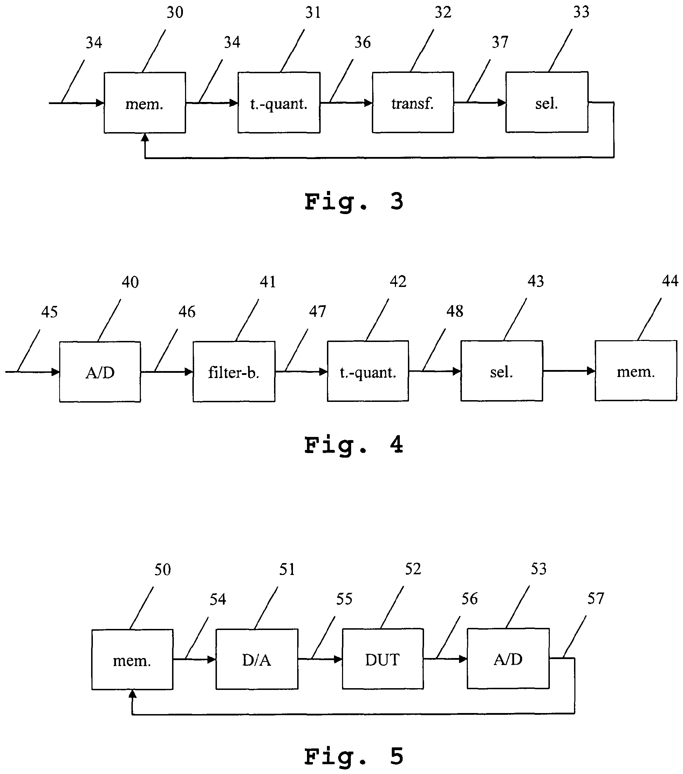

In Fig. 3 wird ein erstes Ausführungsbeispiel der erfindungsgemäßen Messvorrichtung gezeigt. Hier ist ein erster Teil einer solchen Messvorrichtung dargestellt. Eine Speichereinrichtung 30 ist mit einer Zeit-Quantisierungs-Einrichtung 31 verbunden. Die Zeit-Quantisierungs-Einrichtung 31 ist weiterhin mit einer Transformationseinrichtung 32 verbunden. Die Transformationseinrichtung 32 ist darüber hinaus mit einer Selektionseinrichtung 33 verbunden. Der Speichereinrichtung 30 wird ein bereits digital vorliegendes Messsignal 34 zugeführt. Es wird von der Speichereinrichtung 30 zur späteren Verwendung gespeichert. Zu einem späteren Zeitpunkt wird das Messsignal 34 von der Speichereinrichtung 30 an die Zeit-Quantisierungs-Einrichtung 31 übertragen. Diese zerteilt das Messsignal 34 in mehrere Zeit-Teil-Messsignale. Es handelt sich dabei jeweils um einen zeitlichen Abschnitt des Messsignals 34. Die Zeit-Teil-Messsignale 36 werden an die Transformationseinrichtung 32 weitergeleitet. Die Transformationseinrichtung 32 überträgt jedes einzelne Zeit-Teil-Messsignal in den Frequenzbereich und erzeugt so aus jedem Zeit-Teil-Messsignal eine Mehrzahl von Frequenz-Zeit-Teil-Messsignalen 37. Diese werden an die Selektionseinrichtung 33 weitergeleitet. Optional überlappen dabei die Frequenz-Zeit-Teil-Messsignalen 37 im Frequenzbereich. Die Selektionseinrichtung 33 führt eine Selektion der Frequenz-Zeit-Teil-Messsignale 37 durch und leitet die Ergebnisse an die Speichereinrichtung 30 weiter. Die Speichereinrichtung 30 speichert die Ergebnisse der Selektion zur späteren Verwendung ab.

Die Selektionseinrichtung 33 führt die Selektion dabei auf Basis von ihr ermittelter Pegel der einzelnen Frequenz-Zeit-Teil-Messsignale durch. So ermittelt sie anhand eines Mindestpegels, welche Frequenz-Zeit-Teil-Messsignale 37 zur Bestimmung des Frequenzgangs eines Messobjekts geeignet sind. Anhand derselben Schwelle bestimmt sie, welche Frequenz-Zeit-Teil-Messsignale 37 zur Ermittlung des Ruhe-Rauschniveaus des Messobjekts genutzt werden können. Optional wird zur Ermittlung des Ruhe-Rauschniveaus eine abweichende Schwelle eingesetzt. Zwischen den Schwellen kann somit ein Pegelbereich liegen, in welchem die entsprechenden Frequenz-Zeit-Teil-Messsignale ungenutzt bleiben. Die Selektionseinrichtung 33 nutzt eine weitere obere Schwelle, welche eine Sättigung bzw. Übersteuerung des Messobjekts anzeigt. Überschreitet ein Frequenz-Zeit-Teil-Messsignal 37 die zweite obere Schwelle, so wird es zur Messung nicht herangezogen, da die Ergebnisse verfälscht wären.

In Fig. 4 wird ein zweites Ausführungsbeispiel der erfindungsgemäßen Messvorrichtung dargestellt. Hier ist eine alternative Ausführung eines ersten Teils einer solchen Messvorrichtung dargestellt. Ein Analog-Digital-Wandler 40 ist mit einer Filterbank 41 verbunden. Die Filterbank 41 ist mit einer Zeit-Quantisierungs-Einrichtung 42 verbunden. Die Zeit-Quantisierungs-Einrichtung 42 ist weiterhin mit einer Selektionseinrichtung 43 verbunden. Die Selektionseinrichtung 43 ist weiterhin mit einer Speichereinrichtung 44 verbunden.

In diesem Ausführungsbeispiel liegt das Messsignal 45 nicht bereits in digitaler Form vor. Das analoge Messsignal 45 wird dem Analog-Digital-Wandler 40 zugeführt. Dieser digitalisiert das Messsignal 45 zu einem digitalen Messsignal 46. Das digitale Messsignal 46 wird der Filterbank 41 zugeführt. Die Filterbank 41 transformiert das digitale Messsignal 46 in den Frequenzbereich und erzeugt so aus dem digitalen Messsignal 46 eine Vielzahl von Frequenz-Teil-Messsignalen 47. Diese werden an die Zeit-Quantisierungs-Einrichtung 42 übertragen. Die Zeit-Quantisierungs-Einrichtung 42 erzeugt aus jedem einzelnen Frequenz-Teil-Messsignal eine Mehrzahl von Frequenz-Zeit-Teil-Messsignalen 48. D.h. sie zerlegt jedes einzelne Frequenz-Teil-Messsignal in mehrere zeitlich nacheinander liegende Frequenz-Zeit-Teil-Messsignale 48. Diese werden an die Selektionseinrichtung 43 weitergeleitet. Optional überlappen die Frequenz-Zeit-Teil-Messsignalen 48 zeitlich. Die Selektionseinrichtung 43 entspricht der Selektionseinrichtung 33 aus Fig. 3. Die Ergebnisse der Selektion werden wie auch in Fig. 3 an die Speichereinrichtung 44 übertragen und von dieser zur späteren Verwendung gespeichert.

Die anhand von Fig. 3 und Fig. 4 dargestellte Analyse des Messsignals 34 bzw. 45 muss dabei lediglich einmal pro Messsignal durchgeführt werden. Dies muss in keinem zeitlichen Zusammenhang zu der tatsächlichen Messung, welche im Folgenden anhand der Fig. 5 gezeigt wird, stehen.

In Fig. 5 wird ein drittes Ausführungsbeispiel der erfindungsgemäßen Messvorrichtung gezeigt. Ein zweiter Teil der Messvorrichtung ist hier dargestellt. Eine Speichereinrichtung 50 ist mit einem Digital-Analog-Wandler 51 verbunden. Der Digital-Analog-Wandler 51 ist mit einem Messobjekt 52 verbunden. Das Messobjekt 52 ist weiterhin mit einem Analog-Digital-Wandler 53 verbunden.

Der Analog-Digital-Wandler 53 ist erneut mit der Speichereinrichtung 50 verbunden.

Die Speichereinrichtung 50 gibt das bereits wie anhand von Fig. 3 und Fig. 4 analysierte Messsignal 54 an den Digital-Analog-Wandler 51 aus. Der Digital-Analog-Wandler 51 wandelt das digitale Messsignal 54 in ein analoges Messsignal 55 um und beaufschlagt das Messobjekt 52 damit. Das Messsignal 55 durchläuft das Messobjekt 52 und wird als Ausgangssignal 56 ausgegebenen. Es handelt sich dabei um ein analoges Signal. Das analoge Ausgangssignal 56 wird dem Analog-Digital-Wandler 53 zugeführt, welcher es in ein digitales Ausgangssignal 57 wandelt. Das digitale Ausgangssignal 57 wird erneut der Speichereinrichtung 50 zugeführt, welche sie zur späteren Verarbeitung speichert.

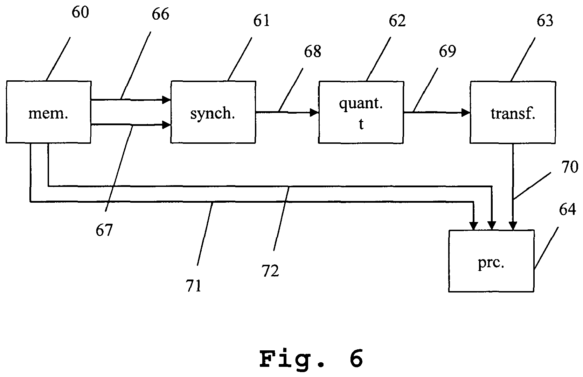

Fig. 6 zeigt ein viertes Ausführungsbeispiel der Erfindungsgemäßen Messvorrichtung. Hier ist ein dritter Teil der Messvorrichtung dargestellt. Eine Speichereinrichtung 60 ist mit einer Synchronisationseinrichtung 61 verbunden. Die Synchronisationseinrichtung 61 ist weiterhin mit einer Zeit-Quantisierungs-Einrichtung 62 verbunden. Diese ist weiterhin mit einer Transformationseinrichtung 63 verbunden. Die Speichereinrichtung 60, die Synchronisationseinrichtung 61 und die Transformationseinrichtung 63 sind darüber hinaus mit einer Verarbeitungseinrichtung 64 verbunden.

In der Speichereinrichtung 60 sind das ursprüngliche Messsignal und das Ausgangssignal des Messobjekts gespeichert. Darüber hinaus ist in der Speichereinrichtung 60 das Ergebnis der Selektion, wie in Fig. 3, bzw. Fig. 4 gezeigt, gespeichert. Die Speichervorrichtung 60 gibt das ursprüngliche Messsignal 66 und das Ausgangssignal 67 an die Synchronisationseinrichtung 61 weiter. Die Synchronisationseinrichtung 61 führt eine Synchronisation der beiden Signale durch. D.h. die Synchronisationseinrichtung 61 ermittelt den genauen Zeitversatz, welcher durch das Durchlaufen des Messobjekts im Ausgangssignal gegenüber dem Messsignal erzeugt wird. Die Synchronisationseinrichtung 61 ermittelt weiterhin den Phasenunterschied zwischen den beiden eingegebenen Signalen. Alternativ ist eine getrennte Ermittlung der Signalverzögerungszeit des Messobjekts, z.B. mittels Tonbursts möglich. Werden die Wiedergabe des ursprünglichen Messsignals und die Aufnahme des Ausgangssignals des Messobjekts genau gleichzeitig gestartet, kann die Synchronisation weiterhin durch eine Zeitverschiebung der beiden gespeicherten Signale gegeneinander um die gemessene Signalverzögerungszeit realisiert werden.

Die Synchronisationseinrichtung 61 überträgt weiterhin ein synchronisiertes Ausgangssignal 68 an die Zeit-Quantisierungs-Einrichtung 62. Diese zerlegt das synchronisierte Ausgangssignal in Zeit-Teil-Ausgangssignale 69. Diese werden an die Transformationseinrichtung 63 übertragen. Die Transformationseinrichtung 63 erzeugt aus jedem einzelnen Zeit-Teil-Ausgangssignal eine Mehrzahl von Frequenz-Zeit-Teil-Ausgangssignalen 70.

Die Frequenz-Zeit-Teil-Ausgangssignale 70 entsprechen in ihrer Lage auf der Zeit-Achse und der Frequenz-Achse den Frequenz-Zeit-Teil-Messsignalen aus Fig. 3 und Fig. 4. Die Frequenz-Zeit-Teil-Ausgangssignale 70 werden an die Verarbeitungseinrichtung 64 übertragen. Von der Speichereinrichtung 60 werden weiterhin eine Mehrzahl von Frequenz-Zeit-Teil-Messsignalen 71 und die Selektionsergebnisse 72 an die Verarbeitungseinrichtung 64 übertragen. Die Verarbeitungseinrichtung 64 vergleicht die Frequenz-Zeit-Teil-Ausgangssignale 70 mit den jeweils zugehörigen Frequenz-Zeit-Teil-Messsignalen 71. Dabei werden die Selektionsergebnisse 72 berücksichtigt. Wie anhand von Fig. 1 und Fig. 2 gezeigt, werden für bestimmte Messungen dabei lediglich bestimmte Teilsignale herangezogen. So bestimmt die Verarbeitungseinrichtung 64 bevorzugt den Amplituden-Frequenzgang des Messobjekts. Auch eine Bestimmung des Phasen-Frequenzgangs ist z.B. durch Anwendung einer komplexen FFT (Fast Fourier Transform) möglich. Darüber hinaus kann das Ruhe-Rauschniveau des Messobjekts bestimmt werden. Durch Mittelung über mehrere Teilsignale wird ein gleichmäßiges Ergebnis erzielt. Das Ergebnis der Messungen kann anschließend optional in einer Speichereinrichtung zur späteren Verwendung gespeichert werden. Alternativ ist eine direkte Ausgabe möglich.

In Fig. 7 wird ein erstes Ausführungsbeispiel des erfindungsgemäßen Messverfahrens gezeigt. In einem ersten Schritt 80 wird eine Analyse des Messsignals durchgeführt. Hierauf wird anhand von Fig. 8 näher eingegangen. In einem zweiten Schritt 81 wird eine Messung an einem Messobjekt durchgeführt. D.h. das Messobjekt wird mit dem Messsignal beaufschlagt, während das Ausgangssignal des Messobjekts gemessen wird. In einem dritten Schritt 83 wird eine Synchronisation des Messsignals und des Ausgangssignals des Messobjekts durchgeführt. Hierzu kann beispielsweise eine Korrelation herangezogen werden. In einem vierten Schritt 83 wird das Ausgangssignal des Messobjekts analysiert. Hierauf wird anhand von Fig. 9 näher eingegangen.

In Fig. 8 wird ein zweites Ausführungsbeispiel des erfindungsgemäßen Messverfahrens dargestellt. Hier dargestellt ist der erste Schritt 80 aus Fig. 7 in größerem Detail. In einem ersten Schritt 90 wird eine zeitliche Quantisierung des Messsignals durchgeführt. D.h. das Messsignal wird in eine Mehrzahl von zeitlich nacheinander liegenden Zeit-Teil-Messsignalen zerlegt. In einem zweiten Schritt 91 wird eine Transformation des Messsignals in den Frequenzbereich durchgeführt. D.h. die Zeit-Teil-Messsignale werden jeweils einer Transformation in den Frequenzbereich unterzogen. Dabei werden sie in einzelne Frequenz-Zeit-Teil-Messsignale zerlegt. In einem dritten Schritt 92 werden diese Frequenz-Zeit-Teil-Messsignale einer Selektion unterzogen. D.h. die Pegel der Teilsignale werden ermittelt und Teilsignale anhand der ermittelten Pegel selektiert. Die Selektion erfolgt dabei wie bereits anhand von Fig. 2 beschrieben.

Fig. 9 zeigt ein drittes Ausführungsbeispiel des erfindungsgemäßen Messverfahrens. Hier dargestellt ist der vierte Schritt 83 aus Fig. 7 in größerem Detail. In einem ersten Schritt 100 wird eine zeitliche Quantisierung des Ausgangssignals des Messobjekts durchgeführt. D.h. das Ausgangssignal wird in eine Mehrzahl von zeitlich nacheinander liegenden Zeit-Teil-Ausgangssignalen zerlegt. In einem zweiten Schritt 101 wird das Ausgangssignal in den Frequenzbereich transformiert. D.h. jedes einzelne Zeit-Teil-Ausgangssignal wird einer Transformation in den Frequenzbereich unterzogen. Dabei wird eine Vielzahl von Frequenz-Zeit-Teil-Ausgangssignalen erzeugt. Diese Teilsignale werden in einem dritten Schritt 102 mit den Frequenz-Zeit-Teil-Messsignalen aus Fig. 8 verglichen. Aufgrund der Synchronisation stimmen die Frequenz-Zeit-Teil-Messsignale mit den Frequenz-Zeit-Teil-Ausgangssignalen hinsichtlich ihrer zeitlichen Lage und ihres Frequenzbereichs überein. Anhand des Vergleichs werden der Frequenzgang und/oder das Ruhe-Rauschniveau ermittelt. Durch Mittelung mehrerer Teilsignale wird ein gleichmäßiges Ergebnis erzielt.

Die Erfindung ist nicht auf das dargestellte Ausführungsbeispiel beschränkt. So können unterschiedliche Messungen durchgeführt werden. Neben dem Amplituden-Frequenzgang und des Ruhe-Rauschniveaus ist auch eine Messung von weiteren Kenngrößen, wie z.B. des Phasen-Frequenzgangs möglich. Alle vorstehend beschriebenen Merkmale oder in den Figuren gezeigten Merkmale sind im Rahmen der Erfindung beliebig vorteilhaft miteinander kombinierbar.

## Patentansprüche

1. Messvorrichtung mit einer ersten Transformationseinrichtung (32, 41), einer ersten Zeit-Quantisierungs-Einrichtung (31, 42) und einer Selektionseinrichtung (33, 43),
wobei die erste Transformationseinrichtung (32, 41) eine Transformation zumindest eines ersten Signals (36, 46) in den Frequenzbereich durchführt,
wobei die erste Zeit-Quantisierungs-Einrichtung (31, 42) zumindest ein zweites Signal (34, 47) in mehrere zeitlich nacheinander liegende Signale (36, 48) aufteilt,
wobei die Selektionseinrichtung (33, 43) eine Selektion von für eine Messung geeigneten Teilsignalen (21, 22) durchführt,
wobei die erste Transformationseinrichtung (32, 41) und die erste Zeit-Quantisierungs-Einrichtung (31, 42) ein Messsignal (34, 46) nacheinander verarbeiten und daraus Frequenz-Zeit-Teil-Messsignale (37, 48) erzeugen, wobei Frequenz-Zeit-Teil-Messsignale (37, 48) Ausschnitte des Messsignals im Zeit- und Frequenz-Bereich sind,
wobei die von der Selektionseinrichtung (33, 43) selektierten Teilsignale (21, 22) Frequenz-Zeit-Teil-Messsignale (37, 48) sind, und
wobei die Selektionseinrichtung (33, 43) für eine Messung geeignete Frequenz-Zeit-Teil-Messsignale (21, 22) durch Vergleich ihrer jeweiligen mittleren Leistung mit einem unteren Schwellwert bestimmt, wobei die Selektionseinrichtung (33, 43) für eine Messung geeignete Frequenz-Zeit-Teil-Messsignale (21, 22) durch Vergleich ihrer jeweiligen mittleren Leistung mit zumindest einem oberen Schwellwert bestimmt, und wobei ein Frequenz-Zeit-Teil-Messsignal (37), welches den oberen Schwellwert überschreitet, nicht zur Messung herangezogen wird.

2. Messvorrichtung nach Anspruch 1,
**dadurch gekennzeichnet,**
**dass** die Messvorrichtung eine Synchronisationseinrichtung (61) beinhaltet, und
**dass** die Synchronisationseinrichtung (61) eine Synchronisation eines Messsignals (54, 66) mit einem von einem Messobjekt (52) ausgegebenen Ausgangssignal (57, 67) durchführt.

3. Messvorrichtung nach Anspruch 2,
**dadurch gekennzeichnet,**
**dass** die Messvorrichtung eine zweite Transformationseinrichtung (63) und eine zweite Zeit-Quantisierungs-Einrichtung (62) beinhaltet,
wobei die zweite Transformationseinrichtung (63) eine Transformation zumindest eines dritten Signals (69) in den Frequenzbereich durch führt,
**dass** die zweite Zeit-Quantisierungs-Einrichtung (62) zumindest ein viertes Signal (68) in mehrere zeitlich nacheinander liegende Signale (69) aufteilt, und
**dass** die zweite Transformationseinrichtung (63) und die zweite Zeit-Quantisierungs-Einrichtung (62) das Ausgangssignal (57, 67) nacheinander verarbeiten und daraus Frequenz-Zeit-Teil-Ausgangssignale (70) erzeugen, wobei Frequenz-Zeit-Teil-Ausgangssignale (70) Ausschnitte des Ausgangssignals (57, 67) im Zeit- und Frequenz-Bereich sind.

4. Messvorrichtung nach Anspruch 3,
**dadurch gekennzeichnet,**
**dass** die Messvorrichtung über eine Verarbeitungseinrichtung (64) verfügt,
**dass** die Verarbeitungseinrichtung (64) Frequenz-Zeit-Teil-Messsignale (71) und zeitlich und im Frequenzbereich zugehörige Frequenz-Zeit-Teil-Ausgangsssignale (70) vergleicht, wobei die Verarbeitungseinrichtung (64) einander zugehörige Frequenz-Zeit-Teil-Messsignale (71) und Frequenz-Zeit-Teil-Ausgangsssignale (70) anhand der Synchronisation durch die Synchronisationseinrichtung (61) ermittelt.

5. Messvorrichtung nach Anspruch 4,
**dadurch gekennzeichnet,**
**dass** die Verarbeitungseinrichtung (64) aus dem Vergleich einen Frequenzgang und/oder ein Rauschniveau bestimmt.

6. Messverfahren,
wobei eine erste Transformation zumindest eines ersten Signals (36, 46) in den Frequenzbereich durchgeführt wird, und
wobei eine erste Aufteilung zumindest eines zweiten Signals (34, 47) in mehrere zeitlich nacheinander liegende Signale (36, 48) durchgeführt wird,
wobei eine Selektion von für eine Messung geeigneten Teilsignalen (21, 22) durchgeführt wird, wobei durch nacheinander Durchführen der ersten Transformation in den Frequenzbereich und der ersten Aufteilung in zeitlich nacheinander liegende Signale (36, 48) Frequenz-Zeit-Teil-Messsignale (37, 48) erzeugt werden, wobei Frequenz-Zeit-Teil-Messsignale (37, 48) Ausschnitte eines Messsignals (34, 46) im Zeit- und Frequenz-Bereich sind,
wobei die selektierten Teilsignale (21, 22) Frequenz-Zeit-Teil-Messsignale (37, 48) sind,
wobei für eine Messung geeignete Frequenz-Zeit-Teil-Messsignale (21, 22) durch Vergleich ihrer jeweiligen mittleren Leistung mit einem unteren Schwellwert bestimmt werden, wobei für eine Messung geeignete Frequenz-Zeit-Teil-Messsignale (21, 22) durch Vergleich ihrer jeweiligen mittleren Leistung mit zumindest einem oberen Schwellwert bestimmt werden, und wobei ein Frequenz-Zeit-Teil-Messsignal (37), welches die obere Schwelle überschreitet, nicht zur Messung herangezogen wird.

7. Messverfahren nach Anspruch 6,
**dadurch gekennzeichnet,**
**dass** eine Synchronisation eines Messsignals (54, 66) mit einem von einem Messobjekt (52) ausgegebenen Ausgangssignal (57, 67) durchgeführt wird.

8. Messverfahren nach Anspruch 7,
**dadurch gekennzeichnet,**
**dass** eine zweite Transformation zumindest eines dritten Signals (69) in den Frequenzbereich durchgeführt wird, dass eine zweite Aufteilung zumindest eines vierten Signals (68) in mehrere zeitlich nacheinander liegende Signale (69) aufgeteilt wird, und
**dass** durch nacheinander Durchführen der zweiten Transformation in den Frequenzbereich und der zweiten Aufteilung in zeitlich nacheinander liegende Signale Frequenz-Zeit-Teil-Ausgangssignale (70) erzeugt werden, wobei Frequenz-Zeit-Teil-Ausgangsssignale (70) Ausschnitte des Ausgangsssignals (57, 67) im Zeit- und Frequenz-Bereich sind.

9. Messverfahren nach Anspruch 8,
**dadurch gekennzeichnet,**
**dass** Frequenz-Zeit-Teil-Messsignale (71) und zeitlich und im Frequenzbereich zugehörige Frequenz-Zeit-Teil-Ausgangsssignale (70) verglichen werden, wobei einander zugehörige Frequenz-Zeit-Teil-Messsignale (71) und Frequenz-Zeit-Teil-Ausgangsssignale (70) anhand der Synchronisation ermittelt werden.

10. Messverfahren nach Anspruch 9,
**dadurch gekennzeichnet,**
**dass** aus dem Vergleich ein Frequenzgang und/oder ein Rauschniveau bestimmt werden.

## Claims

1. Measuring device with a first transformation unit (32, 41), a first time quantization unit (31, 42) and a selection unit (33, 43),
wherein the first transformation unit (32, 41) effects a transformation of at least a first signal (36, 46) into the frequency domain,
wherein the first time quantization unit (31, 42) divides at least a second signal (34, 47) into a plurality of signals (36, 48) lying one after another in time, wherein the selection unit (33, 43) effects a selection of part signals (21, 22) which are suitable for measurement,
wherein the first transformation unit (32, 41) and the first time quantization unit (31, 42) process a measurement signal (34, 46) one after the other and generate frequency-time part measurement signals (37, 48) therefrom, frequency-time part measurement signals (37, 48) being excerpts of the measurement signal in the time domain and frequency domain,
wherein the part signals (21, 22) selected by the selection unit (33, 43) are frequency-time part measurement signals (37, 48), and
wherein the selection unit (33, 43) determines frequency-time part measurement signals (21, 22) which are suitable for measurement by comparing their respective mean power with a lower threshold value,
wherein the selection unit (33, 43) determines frequency-time part measurement signals (21, 22) which are suitable for measurement by comparing their respective mean power with at least one upper threshold value,
and wherein a frequency-time part measurement signal (37) which overshoots the upper threshold value is not used for measurement.

2. Measuring device according to claim 1,
**characterised in that**
the measuring device comprises a synchronisation unit (61), and
**in that** the synchronisation unit (61) effects a synchronisation of a measurement signal (54, 66) with an output signal (57, 67) which is outputted by a measurement object (52).

3. Measuring device according to claim 2,
**characterised in that**
the measuring device comprises a second transformation unit (63) and a second time quantization unit (62), wherein the second transformation unit (63) effects a transformation of at least a third signal (69) into the frequency domain,
**in that** the second time quantization unit (62) divides at least a fourth signal (68) into a plurality of signals (69) lying one after another in time, and
**in that** the second transformation unit (63) and the second time quantization unit (62) process the output signal (57, 67) one after the other and generate frequency-time part output signals (70) therefrom, frequency-time part output signals (70) being excerpts of the output signal (57, 67) in the time domain and frequency domain.

4. Measuring device according to claim 3,
**characterised in that**
the measuring device has a processing unit (64),
**in that** the processing unit (64) compares frequency-time part measurement signals (71) and frequency-time part output signals (70) which are associated in time and in the frequency domain, the processing unit (64) determining frequency-time part measurement signals (71) and frequency-time part output signals (70) which are associated with one another by reference to the synchronisation by the synchronisation unit (61).

5. Measuring device according to claim 4,
**characterised in that**
the processing unit (64) determines a frequency response and/or a noise level from the comparison.

6. Measuring method,
wherein a first transformation of at least a first signal (36, 46) into the frequency domain is effected, and wherein a first division of at least a second signal (34, 47) into a plurality of signals (36, 48) lying one after another in time is effected,
wherein a selection of part signals (21, 22) which are suitable for measurement is effected, frequency-time part measurement signals (37, 48) being generated by successively effecting the first transformation into the frequency domain and the first division into signals (36, 48) lying one after another in time, frequency-time part measurement signals (37, 48) being excerpts of a measurement signal (34, 46) in the time domain and frequency domain,
wherein the selected part signals (21, 22) are frequency-time part measurement signals (37, 48),
wherein frequency-time part measurement signals (21, 22) which are suitable for measurement are determined by comparing their respective mean power with a lower threshold value,
wherein frequency-time part measurement signals (21, 22) which are suitable for measurement are determined by comparing their respective mean power with at least one upper threshold value, and
wherein a frequency-time part measurement signal (37) which overshoots the upper threshold is not used for measurement.

7. Measuring method according to claim 6,
**characterised in that**
a synchronisation of a measurement signal (54, 66) with an output signal (57, 67) outputted by a measurement object (52) is effected.

8. Measuring method according to claim 7,
**characterised in that**
a second transformation of at least a third signal (69) into the frequency domain is effected,
**in that** a second division of at least a fourth signal (68) into a plurality of signals (69) lying after one another in time is effected, and
**in that** frequency-time part output signals (70) are generated by successively effecting the second transformation into the frequency domain and the second division into signals lying after one another in time, frequency-time part output signals (70) being excerpts of the output signal (57, 67) in the time domain and frequency domain.

9. Measuring method according to claim 8,
**characterised in that**
frequency-time part measurement signals (71) and frequency-time part output signals (70) which are associated in time and in the frequency domain are compared, frequency-time part measurement signals (71) and frequency-time part output signals (70) which are associated with one another being determined by reference to the synchronisation.

10. Measuring method according to claim 9,
**characterised in that**
a frequency response and/or a noise level are determined from the comparison.

## Revendications

1. Dispositif de mesure comprenant un premier système de transformation (32, 41), un premier système de quantification temporelle (31, 42) et un système de sélection (33, 43),
dans lequel le premier système de transformation (32, 41) réalise une transformation d'au moins un premier signal (36, 46) dans le domaine fréquentiel,
dans lequel le premier système de quantification temporelle (31, 42) divise au moins un deuxième signal (34, 47) en plusieurs signaux (36, 48) successifs dans le temps,
dans lequel le système de sélection (33, 43) réalise une sélection de parties de signal adaptées à une mesure (21, 22),
dans lequel le premier système de transformation (32, 41) et le premier système de quantification temporelle (31, 42) traitent l'un après l'autre un signal de mesure (34, 36) et génèrent à partir de celui-ci des parties de signal de mesure fréquentielle-temporelle (37, 48), dans lequel les parties de signal de mesure fréquentielle-temporelle (37, 48) sont des portions du signal de mesure dans le domaine temporel et fréquentiel,
dans lequel les parties de signal (21, 22) sélectionnées par le système de sélection (33, 43) sont des parties de signal de mesure fréquentielle-temporelle (37, 48), et
dans lequel le système de sélection (33, 43) détermine les parties de signal de mesure fréquentielle-temporelle adaptées à une mesure (21, 22) par comparaison de la puissance moyenne respective de celles-ci à une valeur seuil inférieure,
dans lequel le système de sélection (33, 43) détermine les parties de signal de mesure fréquentielle-temporelle adaptées à une mesure (21, 22) par comparaison de la puissance moyenne respective de celles-ci à au moins une valeur seuil supérieure,
et dans lequel une partie de signal de mesure fréquentielle-temporelle (37) dépassant la valeur seuil supérieure n'est pas utilisée pour la mesure.

2. Dispositif de mesure selon la revendication 1,
**caractérisé**
**en ce que** le dispositif de mesure comporte un système de synchronisation (61), et
**en ce que** le système de synchronisation (61) réalise une synchronisation d'un signal de mesure (54, 66) avec un signal de sortie (57, 67) émis par un objet à mesurer (52).

3. Dispositif de mesure selon la revendication 2,
**caractérisé**
**en ce que** le dispositif de mesure comporte un deuxième système de transformation (63) et un deuxième système de quantification temporelle (62),
dans lequel le deuxième système de transformation (63) réalise une transformation d'au moins un troisième signal (69) dans le domaine fréquentiel,
**en ce que** le deuxième système de quantification temporelle (62) divise au moins un quatrième signal (68) en plusieurs signaux (69) successifs dans le temps, et
**en ce que** le deuxième système de transformation (63) et le deuxième système de quantification temporelle (62) traitent l'un après l'autre le signal de sortie (57, 67) et génèrent à partir de celui-ci des parties de signal de sortie fréquentielle-temporelle (70),
dans lequel les parties de signal de sortie fréquentielle-temporelle (70) sont des portions du signal de sortie (57, 67) dans le domaine temporel et fréquentiel.

4. Dispositif de mesure selon la revendication 3,
**caractérisé**
**en ce que** le dispositif de mesure dispose d'un système de traitement (64),
**en ce que** le système de traitement (64) compare des parties de signal de mesure fréquentielle-temporelle (71) et des parties de signal de sortie fréquentielle-temporelle (70) associées dans le domaine temporel et fréquentiel, dans lequel le système de traitement (64) détermine les parties de signal de mesure fréquentielle-temporelle (71) et les parties de signal de sortie fréquentielle-temporelle (70) associées les unes aux autres sur la base de la synchronisation par le système de synchronisation (61).

5. Dispositif de mesure selon la revendication 4,
**caractérisé**
**en ce que** le système de traitement (64) détermine une sortie de fréquence et/ou un niveau de bruit à partir de la comparaison.

6. Procédé de mesure,
dans lequel une première transformation d'au moins un premier signal (36, 46) est réalisée dans le domaine fréquentiel, et
dans lequel une première division d'au moins d'un deuxième signal (34, 47) en plusieurs signaux (36, 48) successifs dans le temps est réalisée,
dans lequel une sélection de parties de signal adaptées à une mesure (21, 22) est réalisée, dans lequel des parties de signal de mesure fréquentielle-temporelle (37, 48) sont générées par réalisation successive de la première transformation dans le domaine fréquentiel et de la première division en signaux (36, 48) successifs dans le temps, dans lequel les parties de signal de mesure fréquentielle-temporelle (37, 48) sont des portions d'un signal de mesure (34, 46) dans le domaine temporel et fréquentiel,
dans lequel les parties de signal (21, 22) sélectionnées sont des parties de signal de mesure fréquentielle-temporelle (37, 48),
dans lequel les parties de signal de mesure fréquentielle-temporelle adaptées à une mesure (21, 22) sont déterminées par comparaison de leur puissance moyenne à une valeur seuil inférieure,
dans lequel les parties de signal de mesure fréquentielle-temporelle adaptées à une mesure (21, 22) sont déterminées par comparaison de leur puissance moyenne à au moins une valeur seuil supérieure, et
dans lequel une partie de signal de mesure fréquentielle-temporelle (37), dépassant le seuil supérieur n'est pas utilisée pour la mesure.

7. Procédé de mesure selon la revendication 6,
**caractérisé**
**en ce qu'**une synchronisation d'un signal de mesure (54, 66) avec un signal de sortie (57, 67) émis par un objet à mesurer (52) est réalisée.

8. Procédé de mesure selon la revendication 7,
**caractérisé**
**en ce qu'**une deuxième transformation d'au moins un troisième signal (69) est réalisée dans le domaine fréquentiel,
**en ce qu'**une deuxième division d'au moins un quatrième signal (68) en plusieurs signaux (69) successifs dans le temps est réalisée, et
**en ce qu'**après la réalisation successive de la deuxième transformation dans le domaine fréquentiel et de la deuxième division en signaux successifs dans le temps, des parties de signal de sortie fréquentielle-temporelle (70) sont générées,
dans lequel les parties de signal de sortie fréquentielle-temporelle (70) sont des portions du signal de sortie (57, 67) dans le domaine temporel et fréquentiel.

9. Procédé de mesure selon la revendication 8,
**caractérisé**
**en ce que** des parties de signal de mesure fréquentielle-temporelle (71) et des parties de signal de sortie fréquentielle-temporelle (70) associées dans le domaine temporel et fréquentiel sont comparées, dans lequel les parties de signal de mesure fréquentielle-temporelle (71) et les parties de signal de sortie fréquentielle-temporelle (70) associées les unes aux autres sont déterminées sur la base de la synchronisation.

10. Procédé de mesure selon la revendication 9,
**caractérisé**
**en ce qu'**une sortie de fréquence et/ou un niveau de bruit sont déterminés à partir de la comparaison.
